(19)

Europäisches
Patentamt

European
Patent Office

Office européen
des brevets

(11) **EP 4 756 533 A1**

(12) **EUROPEAN PATENT APPLICATION**

(43) Date of publication:
**10.06.2026 Bulletin 2026/24**

(21) Application number: **25219785.0**

(22) Date of filing: **01.12.2025**

(51) International Patent Classification (IPC):
***G03F 1/24*** *(2012.01)*       ***G03F 1/50*** *(2012.01)*
***G03F 1/80*** *(2012.01)*

(52) Cooperative Patent Classification (CPC):
**G03F 1/24; G03F 1/50; G03F 1/80**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **06.12.2024 JP 2024214021**

(71) Applicant: SHIN-ETSU CHEMICAL CO., LTD.
**Tokyo 100-0005 (JP)**

(72) Inventors:
• **Miyajima, Chiaki**
  **Nishi-Fukushima, Kubiki-ku, Joetsu-shi, Niigata
  (JP)**

• **Sakurai, Keisuke**
  **Nishi-Fukushima, Kubiki-ku, Joetsu-shi, Niigata
  (JP)**
• **Mimura, Shohei**
  **Nishi-Fukushima, Kubiki-ku, Joetsu-shi, Niigata
  (JP)**
• **Inazuki, Yukio**
  **Nishi-Fukushima, Kubiki-ku, Joetsu-shi, Niigata
  (JP)**

(74) Representative: **Schicker, Silvia**
  **Wuesthoff & Wuesthoff
  Patentanwälte und Rechtsanwalt PartG mbB
  Schweigerstraße 2
  81541 München (DE)**

(54) **PHOTOMASK BLANK AND METHOD FOR MANUFACTURING PHOTOMASK**

(57)    The purpose of the present invention is to provide a photomask blank with which a process for removing a hard mask film can be simplified and eventually a mask manufacturing process can be simplified. The photomask blank includes: a substrate; a patterning layer formed of a single layer or multiple layers on the substrate; and a hard mask film on the patterning layer. The hard mask film is made of a material containing chromium and at least one element selected from nitrogen, carbon, and oxygen, a film density of the hard mask film is 6.0 g/cm$^3$ or less, the hard mask film has resistance to dry-etching using a gas containing fluorine and not containing oxygen, and resistance to dry-etching using a gas containing chlorine and not containing oxygen, and the photomask blank satisfies the following formula (1): d/v $\leq$ 60 [min] (1), wherein a film thickness reduction amount per minute of the hard mask film when processed with a sulfuric acid-hydrogen peroxide mixture is v [nm/min] and a film thickness of the hard mask film is d [nm].

EP 4 756 533 A1

**Description**

TECHNICAL FIELD

The present invention relates to a method for manufacturing a photomask to be used when manufacturing a semiconductor integrated circuit or the like, and a photomask blank suitably used in this method.

BACKGROUND ART

In a manufacturing process of a semiconductor device, photolithography technique in which a transfer mask is irradiated with exposure light and a circuit pattern formed on the mask is transferred onto a semiconductor substrate (semiconductor wafer) is repeatedly used.

A wavelength of the exposure light has been mainly 193 nm using an argon fluoride (ArF) excimer laser beam; however, since a further refined pattern needs to be formed due to continuous device pattern refinement in recent years, extreme ultraviolet (referred to as "EUV" hereinafter) lithography technique using EUV light having a further shorter wavelength than the ArF excimer laser beam as the exposure light has come into use.

In lithography using the excimer laser beam having the wavelength of 193 nm, a transmission type projection optical system and a transmission type mask for pattern transfer are used; on the other hand, in EUV lithography, a reflection type optical system and a reflection type mask for pattern transfer are used since the EUV light having the wavelength of about 0.2 to 100 nm, more specifically the wavelength around 13.5 nm, is extremely lowly transmissive to materials, and the conventional transmission type projection optical system and mask cannot be used therefor. The EUV lithography uses short exposure wavelengths and can perform more refined pattern transfer; however, since the exposure apparatus is expensive and there is difficulty in changing facilities or the like from a conventional transmission type to a reflection type, a transmission type photomask and a reflection type photomask are selectively used according to each process of lithography repeatedly performed.

When manufacturing a photomask, processing is performed by forming a resist film on a photomask blank, drawing a pattern with an electron beam, obtaining a resist pattern through development, and dry-etching a patterning layer with the obtained resist pattern as a mask. In the transmission type photomask, a film including a light-shielding film that shields an excimer laser beam, which is exposure light, is the patterning layer. In the reflection type photomask, a light absorbing film that absorbs the exposure light, which is extreme ultraviolet region light, is the patterning layer.

When processing the patterning layer, if a more refined photomask pattern is to be processed while maintaining a film thickness of the resist film without changing it, a ratio of the film thickness to a pattern width, so-called an aspect ratio, becomes high and a shape of the resist pattern is degraded, causing pattern transfer to fail and the resist pattern to fall or peel in some cases. Therefore, it has been needed to reduce burdens on the resist pattern accompanying refinement of a photomask pattern.

In order to solve such a problem in the transmission type mask, a molybdenum silicide film which can be easily etched, compared to a general chromium (Cr) compound film, by fluorine-based dry-etching that hardly damages the resist film has been used.

Further, a method of providing a hard mask film between a resist and the patterning layer has been also practiced. For example, Patent Document 1 describes that an $SiO_2$ film is formed on an $MoSi_2$ film and a pattern of the $SiO_2$ film is used as an etching mask when dry-etching the $MoSi_2$ film using a gas containing chlorine. In addition, for example, Patent Document 2 describes that a chromium film is formed as a light-shielding film on a phase shift film, an $SiO_2$ film is formed as a hard mask film on the chromium film, and a pattern of the $SiO_2$ film is used as a hard mask when etching the chromium film.

A material of a hard mask film may be any material as long as etching selectivity is ensured between the hard mask film and the patterning layer when the patterning layer is dry-etched while using a hard mask pattern as a mask, and when forming a light-shielding film pattern containing silicon or an absorbing film pattern formed of tantalum (Ta) or ruthenium (Ru), a hard mask film containing chromium (Cr) that has resistance to etching using a gas containing fluorine or a gas containing chlorine and not containing oxygen is used. For example, Patent Document 3 proposes a method with which highly accurate processibility can be achieved by processing a light-shielding film containing silicon while using a thin film formed of a chromiumbased material as an etching mask film.

Further, it is known that a film containing chromium (Cr) is generally excellent in adhesion with a resist compared to a film containing silicon, resulting in hardly occurrence of peeling of a resist pattern in a development process. Patent Document 4 discloses a method for improving resist resolution and forming a highly accurate pattern by providing a film containing chromium between a hard mask film containing silicon and the resist when manufacturing a photomask using the hard mask film containing silicon.

As described above, the hard mask film containing chromium (Cr) is sometimes formed in order to achieve more highly accurate processability when patterning a photomask; however, the chromium hard mask film normally needs to be removed by dry-etching using a gas containing chlorine (Cl) and oxygen (O) after a patterning layer is processed, and in the case of manufacturing a photomask using a mask blank provided with the hard mask film containing chromium (Cr), a dry-etching process for peeling the hard mask is needed in addition to a conventional manufacturing process.

CITATION LIST

PATENT LITERATURE

Patent Document 1: JP S63-85553 A
Patent Document 2: JP H07-49558 A
Patent Document 3: JP 2007-241060 A
Patent Document 4: JP 2022-011477 A

SUMMARY OF INVENTION

TECHNICAL PROBLEM

The present invention is implemented in order to solve the problem described above, and an object thereof is to provide a photomask blank capable of simplifying a process for removing a hard mask film and eventually simplifying a photomask manufacturing process, and a method for manufacturing a photomask using it.

SOLUTION TO PROBLEM

To solve the problem described above, the present invention provides a photomask blank comprising:

a substrate;
a patterning layer formed of a single layer or multiple layers on the substrate; and
a hard mask film on the patterning layer,
wherein the hard mask film is made of a material containing chromium and at least one element selected from nitrogen, carbon, and oxygen,
a film density of the hard mask film is 6.0 g/cm$^3$ or less,
the hard mask film has resistance to dry-etching using a gas containing fluorine and not containing oxygen, and resistance to dry-etching using a gas containing chlorine and not containing oxygen, and
the photomask blank satisfies the following formula (1):

$$d/v \leq 60 \ [min] \quad (1)$$

wherein a film thickness reduction amount per minute of the hard mask film when processed with a sulfuric acid-hydrogen peroxide mixture is v [nm/min] and a film thickness of the hard mask film is d [nm].

In the method for manufacturing a photomask using such a photomask blank of the present invention, the hard mask film can be removed in a resist peeling process (resist pattern removal) after the patterning layer is processed. Therefore, according to the photomask blank of the present invention, a process for removing the hard mask film can be simplified and eventually a photomask manufacturing process can be simplified.
For example, for the hard mask film, it is preferable that a chromium content is 60 at% or less, a nitrogen content is 40 at% or more, and a thickness is 10 nm or less.
By the photomask blank including such a hard mask film according to a preferable aspect, the process for removing the hard mask film can be more surely simplified.
Alternatively, for the hard mask film, it is also preferable that a chromium content is 40 at% or less, an oxygen content is 60 at% or more, and a thickness is 10 nm or less.
By the photomask blank including such a hard mask film according to another preferable aspect, the process for removing the hard mask film can be also more surely simplified.
Alternatively, for the hard mask film, it is also preferable that a chromium content is 40 at% or less, a nitrogen content is 15 at% or more and 25 at% or less, an oxygen content is 30 at% or more and 40 at% or less, a carbon content is 15 at% or less, and a thickness is 10 nm or less.
By the photomask blank including such a hard mask film according to yet another preferable aspect, the process for removing the hard mask film can be also more surely simplified.

For example, the patterning layer may be a film including a light-shielding film that shields an excimer laser beam, and the light-shielding film may be made of a material containing silicon and may have a thickness of 30 nm or more and 180 nm or less.

By using such a photomask blank, an excellent transmission type photomask can be manufactured.

Alternatively, the patterning layer may be a film including an absorbing film that absorbs exposure light which is extreme ultraviolet region light, and

the photomask blank may further comprise: a multilayer reflective film that reflects the exposure light between the substrate and the absorbing film; and a protective film for protecting the multilayer reflective film.

By using such a photomask blank, an excellent reflection type photomask can be manufactured.

In this case, the absorbing film can be formed of a material containing at least one element of Ru and Ta.

The absorbing film may be formed of a material containing at least one element of Ru and Ta.

In addition, the present invention provides a method for manufacturing a photomask, wherein

the photomask blank of the present invention is used, and
the hard mask film is removed using a sulfuric acid or a sulfuric acid-hydrogen peroxide mixture.

By such a method for manufacturing a photomask of the present invention, the process for removing the hard mask film can be simplified and eventually the photomask manufacturing process can be simplified.

Further, the present invention provides a method for manufacturing a transmission type photomask, wherein

the photomask blank of the present invention is used, and
the hard mask film is removed using a sulfuric acid or a sulfuric acid-hydrogen peroxide mixture.

By such a method for manufacturing a transmission type photomask of the present invention, the process for removing the hard mask film can be simplified and eventually the photomask manufacturing process can be simplified.

In addition, the present invention provides a method for manufacturing a reflection type photomask, wherein

the photomask blank of the present invention is used, and
the hard mask film is removed using a sulfuric acid or a sulfuric acid-hydrogen peroxide mixture.

By such a method for manufacturing a reflection type photomask of the present invention, the process for removing the hard mask film can be simplified and eventually the photomask manufacturing process can be simplified.

ADVANTAGEOUS EFFECTS OF INVENTION

As described above, according to the photomask blank of the present invention, since the hard mask film containing chromium can be removed continuously with removal of the resist pattern and there is no need to add a new process after washing at the time of peeling the resist, a process of manufacturing a photomask from a mask blank having highly accurate processability can be simplified. That is, according to the photomask blank of the present invention, the process for removing the hard mask film can be simplified and eventually the photomask manufacturing process can be simplified.

BRIEF DESCRIPTION OF DRAWINGS

FIG. 1 is a schematic diagram showing an example of a photoblank of the present invention; and
FIG. 2 is a flowchart showing an example of a method for manufacturing a photomask of the present invention.

DESCRIPTION OF EMBODIMENTS

As described above, it has been demanded to develop a photomask blank capable of simplifying a process for removing a hard mask film and eventually simplifying a photomask manufacturing process.

As a result of intensive studies on the problem, the present inventors have found that, by providing a hard mask film that has a film density of 6.0 g/cm$^3$ or less, has resistance to dry-etching using a gas containing fluorine and not containing oxygen and resistance to dry-etching using a gas containing chlorine and not containing oxygen, and is removable by washing (SPM washing) using a sulfuric acid-hydrogen peroxide mixture (SPM), the hard mask film can be removed in a resist peeling process after a patterning layer is processed, and thus, the problem can be solved, and have completed the present invention.

That is, the present invention is a photomask blank including:

a substrate;
a patterning layer formed of a single layer or multiple layers on the substrate; and
a hard mask film on the patterning layer,
wherein the hard mask film is made of a material containing chromium and at least one element selected from nitrogen, carbon, and oxygen,
a film density of the hard mask film is 6.0 g/cm$^3$ or less,
the hard mask film has resistance to dry-etching using a gas containing fluorine and not containing oxygen, and resistance to dry-etching using a gas containing chlorine and not containing oxygen, and
the photomask blank satisfies the following formula (1):

$$d/v \leq 60 \ [min] \quad (1)$$

wherein a film thickness reduction amount per minute of the hard mask film when processed with a sulfuric acid-hydrogen peroxide mixture is v [nm/min] and a film thickness of the hard mask film is d [nm].

Hereinafter, the present invention will be described in detail, however, the present invention is not limited thereto.

[Photomask Blank]

The photomask blank of the present invention includes:

a substrate;
a patterning layer formed of a single layer or multiple layers on the substrate; and
a hard mask film on the patterning layer,
the hard mask film is made of a material containing chromium and at least one element selected from nitrogen, carbon, and oxygen,
a film density of the hard mask film is 6.0 g/cm$^3$ or less,
the hard mask film has resistance to dry-etching using a gas containing fluorine and not containing oxygen, and resistance to dry-etching using a gas containing chlorine and not containing oxygen, and
the photomask blank satisfies the following formula (1):

$$d/v \leq 60 \ [min] \quad (1)$$

wherein a film thickness reduction amount per minute of the hard mask film when processed with a sulfuric acid-hydrogen peroxide mixture is v [nm/min] and a film thickness of the hard mask film is d [nm].

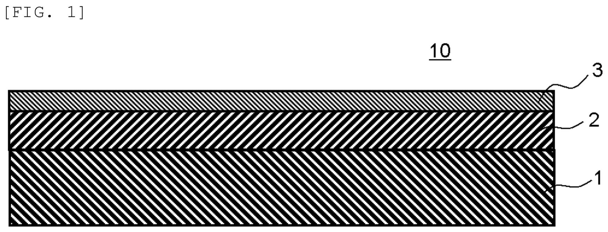

FIG. 1 shows a schematic diagram of an example of a photoblank of the present invention. A photomask blank 10 in FIG. 1 includes a substrate 1, a patterning layer 2 on the substrate 1, and a hard mask film 3 on the patterning layer 2. The patterning layer 2 is described as one layer as an example in FIG. 1, but may be formed of a single layer or multiple layers.

The photomask blank of the present invention may be a transmission type mask blank or may be a reflection type mask blank.

The transmission type mask blank of the present invention may include a substrate which is a transparent substrate, a patterning layer which is a film formed on one main surface (surface) of the substrate and including a light-shielding film that shields exposure light, and a hard mask film formed on the light-shielding film.

The transparent substrate is not limited in particular as long as a material is transparent to the exposure light and is to be deformed a little in heat treatment in manufacturing of a photomask blank and a photomask, and an example is a quartz substrate.

The reflection type mask blank of the present invention may include a substrate, a patterning layer which is a multilayer reflective film that is formed on one main surface (surface) of the substrate and reflects the exposure light, an absorbing film that is formed on the multilayer reflective film and absorbs the exposure light, and a hard mask film on the absorbing film.

In this case, the substrate preferably has a low thermal expansion characteristic for EUV light exposure, and is preferably formed of a material having a thermal expansion coefficient within a range of $\pm 2 \times 10^{-8}$/°C, and preferably $\pm 5 \times$

$10^{-9}$/°C, for example. Examples of such a material include titania-doped quartz glass ($SiO_2$-$TiO_2$-based glass) .

A size of the substrate is preferably such that a size of the main surface of the substrate is 152 mm square and a thickness of the substrate is 6.35 mm. The substrate of this size is a substrate so-called a 6025 substrate (the substrate where the size of the main surface is 6 inches square and the thickness is 0.25 inches).

The exposure light (light used in exposure using a photomask) for which the photomask blank and the photomask of the present invention are used is preferably an ArF excimer laser beam (a wavelength is 193 nm) and extreme ultraviolet (referred to as "EUV" hereinafter) having the wavelength around 13.5 nm.

In the present invention, the patterning layer is a layer on which a mask pattern is to be formed, is a light-shielding film or a phase shift film when the exposure light is the excimer laser beam, is an absorbing film that absorbs the exposure light or the like when the exposure light is extreme ultraviolet region light, and so on. The patterning layer may be a single layer or may be formed of multiple layers. The hard mask film is a film to be an etching mask at the time of patterning of the entire patterning layer when the patterning layer is a single layer, and is a film most on a hard mask side of the patterning layer at least and is a film to be an etching mask at the time of the patterning when the patterning layer is multiple layers.

The hard mask film is preferably in contact with the patterning layer.

In the case where the exposure light is the excimer laser beam, the patterning layer is a light-shielding film or a phase shift film, for example, at the time of a single layer, and is a layer having multiple films selected from a group consisting of a light-shielding film, a phase shift film, and an etching stopper film or the like, for example, when formed of multiple layers.

In the transmission type mask blank, the entire patterning layer is preferably a light-shielding layer when the patterning layer is a single layer, and a layer in contact with the hard mask film or a layer on which a pattern is to be formed while using the hard mask film as a mask is preferably a light-shielding film when the patterning layer is formed of multiple layers.

The light-shielding film is preferably formed of a material containing silicon and preferably contains molybdenum, silicon and nitrogen, for example. The specific examples of the material of the light-shielding film include molybdenum silicon nitride (MoSiN) formed of molybdenum, silicon, and nitrogen, and a molybdenum silicon nitrogen compound containing molybdenum, silicon, nitrogen, and one or more of oxygen and carbon, such as molybdenum silicon nitride oxide (MoSiNO), molybdenum silicon nitride carbide (MoSiNC), and transition metal silicon nitride oxide carbide (MoSiNOC) or the like. The light-shielding film needs to have a sufficient light-shielding property to an ArF exposure wavelength, and a film thickness of the light-shielding film is normally 30 nm or more and 180 nm or less.

The transmission type mask blank which is an example of the photomask blank of the present invention may include an etching prevention film between the substrate and the light-shielding film, and may further include a phase shift film between the etching prevention film and the substrate. The etching prevention film is formed of a material containing chromium, and has a role of preventing the substrate provided in a lower layer or the phase shift film when the phase shift film is provided from being excessively etched, by functioning as an etching stopper at the time of dry-etching the light-shielding film. The phase shift film is a film that changes a phase of the exposure light transmitted through the film by about 180°, for example, as compared with the time when there is no film, usually has a film thickness of 40 nm or more and 100 nm or less, and is formed of a material mainly containing silicon. In addition, the transmission type mask blank of the present invention may include a substrate surface that is processed by the patterning layer.

The reflection type mask blank generally has a basic structure including a substrate with low thermal expansion, a multilayer reflective film that is formed on one of two main surfaces of the substrate and reflects the EUV light, and an absorbing film pattern that is formed on the multilayer reflective film and absorbs the EUV light. When the exposure light is the extreme ultraviolet region light, the patterning layer is an absorbing film or a phase shift film at the time of a single layer, and is a layer having multiple films of an absorbing film, a phase shift film, and an etching stopper film or the like at the time of multiple layers. The entire patterning layer is preferably an absorbing film when the patterning layer is a single layer, and a layer in contact with the hard mask layer or a layer on which a pattern is to be formed while using the hard mask layer as a mask is preferably an absorbing film when the patterning layer is formed of multiple layers. The absorbing film may be a film that has a phase shift effect of changing the phase by about 170 to 240° as compared with the time when there is no absorbing film.

The absorbing film may be a single layer or multiple layers, and an antireflection layer or the like may be formed on a surface. The absorbing film is a film that absorbs the EUV light, and is preferably a material to be dry-etched with a gas containing fluorine and not containing oxygen or containing chlorine and not containing oxygen in the present invention, and specific examples of the material of the absorbing film include a material containing at least one element of Ru, Ta, Ir, Pt, Rh, and Si, and more preferably at least one of Ru and Ta.

The reflection type mask blank which is an example of the photomask blank of the present invention may include a protective film between the multilayer reflective film and the absorbing film, the protective film protecting the multilayer reflective film. The protective film is also referred to as a capping film. The protective film is a film for protecting the multilayer reflective film. The protective film is normally provided in contact with the multilayer reflective film. Examples of a material forming the protective film include a ruthenium (Ru) compound.

The hard mask film is a film that functions as an etching mask when dry-etching the patterning layer, for example, the light-shielding film (in the case of the transmission type mask blank) or the absorbing film (in the case of the reflection type mask blank).

The hard mask film that is included in the photomask blank of the present invention and is formed of the material containing chromium (Cr) can be dry-etched using a gas containing chlorine (Cl) and oxygen (O). On the other hand, the hard mask film included in the photomask blank of the present invention has the resistance to the dry-etching using the gas containing fluorine and not containing oxygen, and the resistance to the dry-etching using the gas containing chlorine and not containing oxygen.

From a viewpoint of functioning as a dry-etching mask, the film thickness of the hard mask film is more preferably 5 nm or more and is more preferably 10 nm or less.

In addition, generally, in the dry-etching for processing the patterning layer, it is preferable that etching resistance of the hard mask film is high, that is, an etching speed is low. In the case of using the hard mask film having the thickness of 5 nm to 10 nm, the etching speed in the dry-etching using the gas containing fluorine and not containing oxygen is preferably 0.3 nm/min or less, and more preferably 0.2 nm/min or less. Further, in the case of using the hard mask film having the thickness of 5 nm to 10 nm, the etching speed in the dry-etching using the gas containing chlorine and not containing oxygen is preferably 0.3 nm/min or less, and more preferably 0.2 nm/min or less.

In the photomask blank of the present invention, the hard mask film can be easily removed by the SPM washing. More specifically, the photomask blank satisfies the following formula (1):

$$d/v \leq 60 \ [\text{min}] \quad (1)$$

wherein the film thickness reduction amount per minute of the hard mask film when processed with the sulfuric acid-hydrogen peroxide mixture is v [nm/min] and the film thickness of the hard mask film is d [nm].

In the photomask blank of the present invention, the hard mask film containing chromium (Cr) has the film density of 6.0 g/cm$^3$ or less so as to be easily removed by the SPM washing.

Note that, in the present invention, the SPM is a solution which is a mixture of sulfuric acid and hydrogen peroxide aqueous solution, for example, a solution produced by mixing 96% sulfuric acid and 30% hydrogen peroxide aqueous solution by a 3:1 volume ratio, and washing using the SPM is called the SPM washing.

Further, a chromium content in the hard mask film is preferably 60 at% or less, more preferably 45 at% or less, and furthermore preferably 40 at% or less. The hard mask film is formed of a material containing at least one element selected from a group consisting of oxygen (O), nitrogen (N), and carbon (C), in addition to chromium (Cr). Specific examples of the material containing chromium (Cr) include a chromium (Cr) compound such as CrO, CrN, CrON, and CrCON. In the case where the hard mask film is a film formed of chromium and nitrogen, the chromium content in the hard mask film is preferably 60 at% or less, and a nitrogen content is preferably 40 at% or more. In the case where the hard mask film is a film formed of chromium and oxygen, the chromium content in the hard mask film is preferably 40 at% or less, and an oxygen content is preferably 60 at% or more. In the case where the hard mask film is a film formed of chromium, oxygen, nitrogen, and carbon, the chromium content in the hard mask film is preferably 40 at% or less, the nitrogen content is preferably 15 at% or more and 25 at% or less, the oxygen content is preferably 30 at% or more and 40 at% or less, and a carbon content is preferably 15 at% or less.

In addition, in the photomask blank of the present invention, a resist film may be formed in contact with a side (a main surface on a side opposite to the substrate) away from the substrate of the hard mask film.

Each layer forming the photomask blank of the present invention is preferably formed by a sputtering method with which a film with excellent homogeneity can be easily obtained, and either method of DC sputtering and RF sputtering can be used. A target and a sputtering gas are appropriately selected according to a layer configuration and a composition. A film formed of the material containing chromium can be formed by reactive sputtering using a chromium target or a target for which any one or two or more selected from oxygen, nitrogen, and carbon is added to chromium or the like and using a sputtering gas for which a reactive gas selected from an oxygen-containing gas, a nitrogen-containing gas, and a carbon-containing gas or the like is appropriately added according to the film to be formed to a rare gas (inert gas) such as a helium gas, a neon gas, and an argon gas.

In particular, in the case of forming the above-described hard mask film which has the film density of 6.0 g/cm$^3$ or less, has the resistance to the dry-etching using the gas containing fluorine and not containing oxygen and the resistance to the dry-etching using the gas containing chlorine and not containing oxygen, and satisfies d/v ≤ 60 [min] (1), it is preferable that a pressure when forming the film is 0.10 Pa or more, 0.12 Pa or more in particular. However, a method for manufacturing the hard mask film included in the photomask blank of the present invention is not limited to this method.

In the photomask blank of the present invention described above, this hard mask film can be valuably used as an etching mask for the patterning layer since it has excellent etching resistance to the dry-etching used in processing of the patterning layer. In addition, since this hard mask film can be easily removed by the washing (SPM washing) using the sulfuric acid-hydrogen peroxide mixture (SPM), the hard mask film can be removed in a resist peeling process after the patterning layer is processed. Therefore, since there is no need to add a new process after washing at the time of peeling the resist, a process of manufacturing the photomask from the mask blank having highly accurate processability can be simplified. That is, according to the photomask blank of the present invention, the process for removing the hard mask film can be simplified and eventually the photomask manufacturing process can be simplified.

[Method for Manufacturing Photomask]

In a method for manufacturing a photomask of the present invention,

the photomask blank of the present invention is used, and
the hard mask film is removed using a sulfuric acid or a sulfuric acid-hydrogen peroxide mixture.

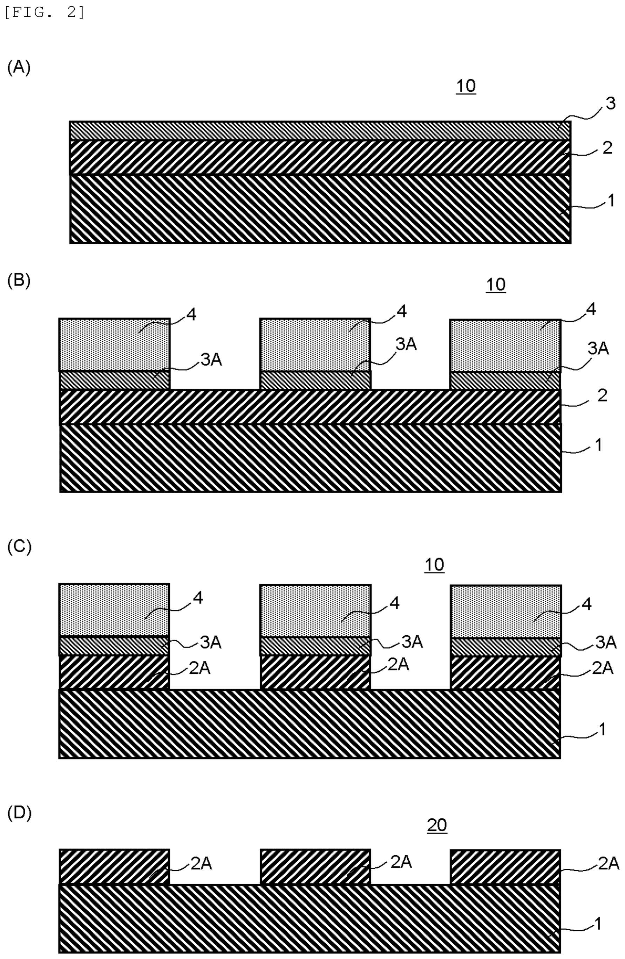

Hereinafter, an example of the method for manufacturing the photomask of the present invention will be described with reference to FIG. 2. However, the method for manufacturing the photomask of the present invention is not limited to the example shown in FIG. 2.

First, as shown in FIG. 2 (A), the photomask blank of the present invention is provided. In this example, the photomask blank 10 shown in FIG. 1 is used.

Next, a resist film (not shown) is applied to the hard mask film 3 of the photomask blank 10. Then, the resist film is subjected to exposure and development and a resist pattern is formed.

Next, while using the resist pattern as an etching mask, the hard mask film 3 is processed by, for example, the dry-etching. Thus, a hard mask pattern 3A as shown in FIG. 2(B), for example, is obtained. On the hard mask pattern 3A, a resist pattern 4 remains.

Then, while using the hard mask pattern 3A as an etching mask, the patterning layer 2 is processed. Thus, as shown in FIG. 2(C), a patterned patterning layer 2A is obtained.

Note that, in this stage, the hard mask pattern 3A and the resist pattern 4 remain on the patterning layer 2A.

Next, the resist pattern 4 is removed by the washing using the sulfuric acid or the sulfuric acid-hydrogen peroxide mixture. By the simultaneous or succeeding washing using the sulfuric acid or the sulfuric acid-hydrogen peroxide mixture, the hard mask film 3, more precisely the hard mask pattern 3A, can be removed.

By removing the hard mask film 3, as shown in FIG. 2(D), a photomask 20 including the substrate 1 and the patterned patterning layer 2A on the substrate 1 is obtained.

In this way, in the method for manufacturing the photomask of the present invention, the hard mask film can be easily removed by the washing (SPM washing) using the sulfuric acid or the sulfuric acid-hydrogen peroxide mixture (SPM) so that the hard mask film can be removed in the resist peeling process after the patterning layer is processed. Thus, since there is no need to add a new process after washing at the time of peeling the resist, a process of manufacturing the photomask from the mask blank having highly accurate processability can be simplified. That is, according to the method for manufacturing the photomask of the present invention, the process for removing the hard mask film can be simplified and eventually the photomask manufacturing process can be simplified.

By using the transmission type mask blank, a transmission type photomask can be manufactured. Alternatively, by using the reflection type mask blank, a reflection type photomask can be manufactured.

EXAMPLES

Hereinafter, the present invention will be specifically described with reference to Examples and Comparative Examples; however, the present invention is not limited thereto.

(Example 1)

On a transparent substrate made of quartz having a size of 152 mm square and a thickness of about 6 mm, sputtering was performed while using a chromium target as a target, using argon and nitrogen as a sputtering gas, adjusting a flow rate of the sputtering gas and setting a pressure when forming a film to 0.12 Pa. As a result, a nitrogen-containing chromium film as a hard mask film with the chromium content being 51 at%, the nitrogen content being 49 at%, and the thickness being 10 nm was formed. Note that a composition of the hard mask film was measured using an X-ray photoelectron spectroscopic analyzer, the thickness was measured using a stylus type film thickness measuring instrument, and the film density was calculated by X-ray reflectivity measurement (XRR).

For the hard mask film, a solution (SPM) prepared by mixing 96 wt% sulfuric acid and 30 wt% hydrogen peroxide aqueous solution by the 3:1 volume ratio was continuously applied to a sample for six minutes. Thereafter, the hard mask film is rinsed with pure water for one minute. After repeating the above-described operation for three times, the film thickness of the hard mask film was measured and a film thickness reduction amount was obtained. As a result, the film thickness reduction amount per minute of the hard mask film to the sulfuric acid-hydrogen peroxide mixture SPM was 0.30 nm/min.

(Example 2)

Similarly to Example 1 except that argon, nitrogen, and oxygen were used as the sputtering gas and the pressure when forming the film was set to 0.17 Pa, an oxygen-containing chromium film with the chromium content being 35 at%, the oxygen content being 65 at%, and the thickness being 10 nm was formed as the hard mask film. Note that even though nitrogen was used when forming the hard mask film, it was hardly detected (less than 1 at%) in composition analysis.
As a result of obtaining the film thickness reduction amount per minute of this hard mask film to the SPM similarly to Example 1, it was 0.19 nm/min.

(Example 3)

Similarly to Example 1 except that argon, nitrogen, oxygen, and carbon dioxide were used as the sputtering gas and the pressure when forming the film was set to 0.16 Pa, an oxygen, nitrogen, and carbon-containing chromium film with the chromium content being 32 at%, the oxygen content being 36 at%, the nitrogen content being 20 at%, the carbon content being 12 at%, and the thickness being 10 nm was formed as the hard mask film.
As a result of obtaining the film thickness reduction amount per minute of this hard mask film to the SPM similarly to Example 1, it was 0.25 nm/min.

(Comparative Example 1)

Similarly to Example 1 except that only argon was used as the sputtering gas and the pressure when forming the film was set to 0.06 Pa, a chromium film of 100 at% chromium with the thickness being 10 nm was formed as the hard mask film.
As a result of obtaining the film thickness reduction amount per minute of this hard mask film to the SPM similarly to Example 1, it was 0.05 nm/min.

(Comparative Example 2)

Similarly to Example 1 except that the pressure when forming the film was set to 0.08 Pa, a nitrogen-containing chromium film with the chromium content being 79 at%, the nitrogen content being 21 at%, and the thickness being 10 nm was formed.
As a result of obtaining the film thickness reduction amount per minute of this chromium film to the SPM similarly to Example 1, it was 0.13 nm/min.
Table 1 below shows the pressure when forming the film and physical properties of the hard mask films in Examples 1 to 3 and Comparative Examples 1 and 2.

[Table 1]

| | Composition | | | | Pressure when Forming Film [Pa] | Film Density [g/cm³] | Film Thickness Variation Amount per Minute of SPM Washing [nm] | Film Thickness Variation Amount in 60 Minutes of SPM Washing [nm] | d/v [min] |
|---|---|---|---|---|---|---|---|---|---|
| | Chromium (at%) | Oxygen (at%) | Nitrogen (at%) | Carbon (at%) | | | | | |
| Example 1 | 51 | 0 | 49 | 0 | 0.12 | 5.91 | 0.30 | 17.8 | 33.3 |
| Example 2 | 35 | 65 | <1 | 0 | 0.17 | 3.30 | 0.19 | 11.4 | 52.6 |
| Example 3 | 32 | 36 | 20 | 12 | 0.16 | 3.69 | 0.25 | 15.0 | 40 |
| Comparative Example 1 | 100 | 0 | 0 | 0 | 0.06 | 7.11 | 0.05 | 3.0 | 200 |
| Comparative Example 2 | 79 | 0 | 21 | 0 | 0.08 | 6.89 | 0.13 | 7.9 | 76.9 |

Generally, the thickness of the hard mask film of the chromium film used with an intention to thin the resist is more preferably 5 nm or more and more preferably 10 nm or less. For the hard mask films in Examples 1 to 3 exhibiting the compositions, the film densities and d/v values shown in Table 1, in the case of using a hard mask of 5 nm to 10 nm, the chromium hard mask film becomes peelable by the SPM washing of less than 60 minutes.

On the other hand, in Comparative Example 1 and Comparative Example 2, in the case of removing the chromium hard mask film of the thickness of about 10 nm by the SPM, the SPM washing needs to be performed for 60 minutes or more. In the case of performing the washing for a long time in this way, change in property and generation of haze caused by the SPM are concerned depending on the composition of the film right under the Cr film hard mask. Therefore, it is not practical to remove the hard mask film formed in Comparative Example 1 or 2 by the SPM.

(Etching Resistance Test)

The etching speeds for thin films formed similarly to the hard mask films obtained in Examples 1 to 3 and Comparative Examples 1 and 2 were examined. As a result, in the dry-etching using $SF_6$ and the dry-etching using $Cl_2$, the etching speeds of all the films were 0.2 nm/min or less.

From this result, it is recognized that each of the films formed in Examples 1 to 3 is formed on the patterning layer usable in the photomask blank to manufacture the photomask blank, a pattern is formed on the hard mask film of the photomask blank by resist method to obtain a hard mask pattern, and this hard mask pattern is used as an etching mask, and thus the patterning layer can be processed with high accuracy.

In addition, since the films formed in Examples 1 to 3 can be easily removed by the SPM as described above, the hard mask film can be removed in the resist peeling process after the patterning layer is processed. That is, it was proved by Examples 1 to 3 that, according to the photomask blank of the present invention, the process for removing the hard mask film can be simplified and eventually the photomask manufacturing process can be simplified.

The present description includes the following inventions.

[1] A photomask blank comprising: a substrate; a patterning layer formed of a single layer or multiple layers on the substrate; and a hard mask film on the patterning layer, wherein the hard mask film is made of a material containing chromium and at least one element selected from nitrogen, carbon, and oxygen, a film density of the hard mask film is 6.0 g/cm$^3$ or less, the hard mask film has resistance to dry-etching using a gas containing fluorine and not containing oxygen, and resistance to dry-etching using a gas containing chlorine and not containing oxygen, and the photomask blank satisfies the following formula (1): d/v ≤ 60 [min] (1) wherein a film thickness reduction amount per minute of the hard mask film when processed with a sulfuric acid-hydrogen peroxide mixture is v [nm/min] and a film thickness of the hard mask film is d [nm].

[2] The photomask blank according to [1], wherein, for the hard mask film, a chromium content is 60 at% or less, a nitrogen content is 40 at% or more, and a thickness is 10 nm or less.

[3] The photomask blank according to [1], wherein, for the hard mask film, a chromium content is 40 at% or less, an oxygen content is 60 at% or more, and a thickness is 10 nm or less.

[4] The photomask blank according to [1], wherein, for the hard mask film, a chromium content is 40 at% or less, a nitrogen content is 15 at% or more and 25 at% or less, an oxygen content is 30 at% or more and 40 at% or less, a carbon content is 15 at% or less, and a thickness is 10 nm or less.

[5] The photomask blank according to any one of [1] to [4], wherein the patterning layer is a film including a light-shielding film that shields an excimer laser beam, and the light-shielding film is made of a material containing silicon and has a thickness of 30 nm or more and 180 nm or less.

[6] The photomask blank according to any one of [1] to [4], wherein the patterning layer is a film including an absorbing film that absorbs exposure light which is extreme ultraviolet region light, and the photomask blank further comprises: a multilayer reflective film that reflects the exposure light between the substrate and the absorbing film; and a protective film for protecting the multilayer reflective film.

[7] The photomask blank according to [6], wherein the absorbing film is formed of a material containing at least one element of Ru and Ta.

[8] A method for manufacturing a photomask, wherein the photomask blank according to claim 1 is used, and the hard mask film is removed using a sulfuric acid or a sulfuric acid-hydrogen peroxide mixture.

[9] A method for manufacturing a transmission type photomask, wherein the photomask blank according to [1] or [5] is used, and the hard mask film is removed using a sulfuric acid or a sulfuric acid-hydrogen peroxide mixture.

[10] A method for manufacturing a reflection type photomask, wherein the photomask blank according to [1], [6], or [7] is used, and the hard mask film is removed using a sulfuric acid or a sulfuric acid-hydrogen peroxide mixture.

It should be noted that the present invention is not limited to the above-described embodiment. The embodiment are just an example, and any example that substantially has the same feature and demonstrates the same functions and effects as those in the technical concept disclosed in claims of the present invention is included in the technical scope of the present invention.

## Claims

1. A photomask blank comprising:

   a substrate;
   a patterning layer formed of a single layer or multiple layers on the substrate; and
   a hard mask film on the patterning layer,
   wherein the hard mask film is made of a material containing chromium and at least one element selected from nitrogen, carbon, and oxygen,
   a film density of the hard mask film is 6.0 g/cm$^3$ or less,
   the hard mask film has resistance to dry-etching using a gas containing fluorine and not containing oxygen, and resistance to dry-etching using a gas containing chlorine and not containing oxygen, and
   the photomask blank satisfies the following formula (1):

   $$d/v \leq 60 \ [min] \quad (1)$$

   wherein a film thickness reduction amount per minute of the hard mask film when processed with a sulfuric acid-hydrogen peroxide mixture is v [nm/min] and a film thickness of the hard mask film is d [nm].

2. The photomask blank according to claim 1, wherein, for the hard mask film, a chromium content is 60 at% or less, a nitrogen content is 40 at% or more, and a thickness is 10 nm or less.

3. The photomask blank according to claim 1, wherein, for the hard mask film, a chromium content is 40 at% or less, an oxygen content is 60 at% or more, and a thickness is 10 nm or less.

4. The photomask blank according to claim 1, wherein, for the hard mask film, a chromium content is 40 at% or less, a nitrogen content is 15 at% or more and 25 at% or less, an oxygen content is 30 at% or more and 40 at% or less, a carbon content is 15 at% or less, and a thickness is 10 nm or less.

5. The photomask blank according to any one of claims 1 to 4, wherein the patterning layer is a film including a light-shielding film that shields an excimer laser beam, and the light-shielding film is made of a material containing silicon and has a thickness of 30 nm or more and 180 nm or less.

6. The photomask blank according to any one of claims 1 to 4, wherein

   the patterning layer is a film including an absorbing film that absorbs exposure light which is extreme ultraviolet region light, and
   the photomask blank further comprises: a multilayer reflective film that reflects the exposure light between the substrate and the absorbing film; and a protective film for protecting the multilayer reflective film.

7. The photomask blank according to claim 6, wherein the absorbing film is formed of a material containing at least one element of Ru and Ta.

8. A method for manufacturing a photomask, wherein

   the photomask blank according to claim 1 is used, and
   the hard mask film is removed using a sulfuric acid or a sulfuric acid-hydrogen peroxide mixture.

9. A method for manufacturing a transmission type photomask, wherein

   the photomask blank according to claim 1 or 5 is used, and
   the hard mask film is removed using a sulfuric acid or a sulfuric acid-hydrogen peroxide mixture.

10. A method for manufacturing a reflection type photomask, wherein

the photomask blank according to claim 1, 6, or 7 is used, and
the hard mask film is removed using a sulfuric acid or a sulfuric acid-hydrogen peroxide mixture.

[FIG. 1]

[FIG. 2]

(A)

(B)

(C)

(D)

Europäisches
Patentamt

European
Patent Office

Office européen
des brevets

# EUROPEAN SEARCH REPORT

**Application Number**

EP 25 21 9785

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/201576 A1 (KAWAHARA HIROTOMO [US] ET AL) 20 June 2024 (2024-06-20) | 1-4,6,7 | INV. G03F1/24 |
| Y | * 46-347; figure 1; examples 5, 6, 9, 10 * | 8,10 | G03F1/50 G03F1/80 |
| | ----- | | |
| X | US 2013/078554 A1 (SAKAI KAZUYA [JP] ET AL) 28 March 2013 (2013-03-28) | 1,3,4,6,7 | |
| Y | * 117, 142, 149-175; figure 1; table 1 * | 8,10 | |
| | ----- | | |
| X | KR 100 948 770 B1 (S&S TECH CO LTD [KR]) 24 March 2010 (2010-03-24) | 1-5 | |
| Y | * 90-99, 104-110, 132-134; claim 9; figure 1 * | 8,9 | |
| | ----- | | |
| Y | US 2022/299862 A1 (AKAGI DAIJIRO [JP] ET AL) 22 September 2022 (2022-09-22) * 38-156; figures 1, 7, 8 * | 8-10 | |
| | ----- | | |

**TECHNICAL FIELDS SEARCHED (IPC)**

G03F

The present search report has been drawn up for all claims

| Place of search | Date of completion of the search | Examiner |
|---|---|---|
| Munich | 22 April 2026 | Brächer, Thomas |

EPO FORM 1503 03.82 (P04C01)

**EP 4 756 533 A1**

## ANNEX TO THE EUROPEAN SEARCH REPORT
## ON EUROPEAN PATENT APPLICATION NO.

EP 25 21 9785

22-04-2026

| Patent document cited in search report | | Publication date | Patent family member(s) | | Publication date |
|---|---|---|---|---|---|
| US 2024201576 | A1 | 20-06-2024 | JP | 2024147757 A | 16-10-2024 |
| | | | JP | WO2020235612 A1 | 26-11-2020 |
| | | | KR | 20220006543 A | 17-01-2022 |
| | | | SG | 11202112745R A | 30-12-2021 |
| | | | TW | 202043908 A | 01-12-2020 |
| | | | US | 2022075256 A1 | 10-03-2022 |
| | | | US | 2024201576 A1 | 20-06-2024 |
| | | | WO | 2020235612 A1 | 26-11-2020 |
| US 2013078554 | A1 | 28-03-2013 | JP | 6125772 B2 | 10-05-2017 |
| | | | JP | 6343690 B2 | 13-06-2018 |
| | | | JP | 2013084910 A | 09-05-2013 |
| | | | JP | 2017062521 A | 30-03-2017 |
| | | | KR | 20130034634 A | 05-04-2013 |
| | | | TW | 201329612 A | 16-07-2013 |
| | | | TW | 201642016 A | 01-12-2016 |
| | | | US | 2013078554 A1 | 28-03-2013 |
| | | | US | 2015261083 A1 | 17-09-2015 |
| KR 100948770 | B1 | 24-03-2010 | NONE | | |
| US 2022299862 | A1 | 22-09-2022 | JP | WO2021132111 A1 | 01-07-2021 |
| | | | KR | 20220122614 A | 02-09-2022 |
| | | | TW | 202131086 A | 16-08-2021 |
| | | | US | 2022299862 A1 | 22-09-2022 |
| | | | WO | 2021132111 A1 | 01-07-2021 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S6385553 A
- JP H0749558 A
- JP 2007241060 A
- JP 2022011477 A